# EUROPEAN PATENT SPECIFICATION

(11) **EP 0 838 689 B1**
(45) Date of publication and mention of the grant of the patent: **06.10.2004**
(21) Application number: 97111061.4
(22) Date of filing: 02.07.1997
(51) Int. Cl.: G06F 11/267

(54) **Test of circuits with Schmitt inputs**
Prüfung von Schaltungen mit Schmitt-Eingängen
Test des circuits avec entrées de Schmitt

(30) Priority: 03.10.1996 JP 26283696
(43) Date of publication of application: 29.04.1998
(73) Proprietor: Oki Electric Industry Co., Ltd., Tokyo (JP)
(72) Inventor: Ohie, Mitsuya, 7-12, Toranomon 1-chome, Minato-ku Tokyo (JP); Inoue, Kazutoshi, 7-12, Toranomon 1-chome, Minato-ku Tokyo (JP); Nagatome, Toshihide, 7-12, Toranomon 1-chome, Minato-ku Tokyo (JP)
(74) Representative: Betten & Resch

(56) References cited:
- PATENT ABSTRACTS OF JAPAN vol. 11, no. 58 (P-550), 21 February 1987 & JP 61 223671 A (TOSHIBA CORP.), 4 October 1986,
- PATENT ABSTRACTS OF JAPAN vol. 8, no. 6 (P-247), 12 January 1984 & JP 58 169069 A (FUJITSU K.K.), 5 October 1983,
- PATENT ABSTRACTS OF JAPAN vol. 7, no. 30 (P-173), 5 February 1983 & JP 57 182660 A (FUJI XEROX K.K.), 10 November 1982,

## Description

### BACKGROUND OF THE INVENTION

### 1. Field of the Invention

The present invention relates to an integrated circuit, more particularly, to an integrated circuit having Schmitt input circuits.

### 2. Description of the Related Art

As known, when an input signal which varies slowly (e.g. µsec order) is inputted into an integrated circuit having an signal threshold type input circuit, a phenomenon (hazard) which a signal inputted into an internal logic circuit become abnormal temporally occurs. Thus, most of integrated circuits are provided with Schmitt input circuits in order to prevent hazard.

When an integrated circuit having Schmitt input circuits is fabricated, it is necessary to test whether hysteresis width, namely, threshold voltages at a H (high) side/a L (low) side of each Schmitt input circuit are predetermined values or not. Conventionally, the test, which is so-called functional test, is performed by operating the internal logic circuit. Concretely, when the H side threshold voltage (V_{TH}) of a Schmitt input circuit is measured, the functional test is repeated while the level of the signal inputted to the Schmitt input circuit is increased by a predetermined amount (e.g. 0.1V) from the GND level. Then, it is determined whether the signal inputted into the Schmitt circuit is recognized as "H" or as "L" every functional test based on the result, and the input signal level at a time which the recognized result changes from "L" to "H" is defined as the V_{TH}. When the L side threshold voltage (V_{TL}) is also measured, the functional test is repeated while the level of the signal inputted to the Schmitt input circuit is lowered.

As above described, in the conventional integrated circuit, the repeated functional test is required to test the Schmitt input circuit, therefore, there is a problem that it takes a long time to test the Schmitt input circuit. Particularly, in a large standardized LSI such as a micro processor or a micro controller, the "functional test" is just complex and takes a long time, therefore, it takes a very long time to complete the test of all Schmitt input circuits mounted on such a LSI.

Moreover, the above described test of the Schmitt input circuit is performed with a LSI tester and the like, therefore, there is another problem that the measurement accuracy of the threshold voltage lowers influenced by power noises in that test environment (e.g. tests with a test board and a test socket). Particularly, in a micro controller or the like having a original oscillated frequency about 10-30 MHz, GND and V_{DD} noises about 0.1-0.3 V occur. Thus, though the V_{TH} and the V_{TL} of the Schmitt input circuit are measured under such an environment, accurate values can not be obtained. Usually, a value larger than a real value is measured as the V_{TH}, and a value smaller than a real value is measured as the V_{TL}. To reduce these measuring errors, the noise occurrence amount is decreased by lowering the original oscillated frequency while threshold voltages are measured, however, the functional test requires a longer time when the original oscillated frequency is lowered.

In Patent Abstracts of Japan JP 61223671, a Schmitt trigger input buffer circuit is disclosed to test accurately and easily whether operation is normal or not by controlling gates different in threshold in accordance with setting of the test mode to perform a test corresponding to the selected mode. The Schmitt trigger input buffer circuit employs a first and a second test mode. In the first test mode high and low level signals are input to test mode setting pins, respectively, a NAND gate to which the output from another NAND gate to a buffer is fed back and the output of one of the pins passing an inverter is supplied is always turned off. In the second test mode a low and a high level signal are input to said pins respectively, the transfer operation is performed in the threshold voltage of the first NAND gate, and it is tested accurately and easily whether a Schmitt trigger input buffer circuit having a hysteresis characteristic is normal or not by two kinds of threshold voltage.

As above described, the conventional integrated circuit has problems that it takes a long time to test the Schmitt input circuit and the accuracy of the test result is not good, and the cost increases caused by those problems.

### SUMMARY OF THE INVENTION

Accordingly, it is an object of the present invention to provide an integrated circuit in which it is possible to test Schmitt input circuits in a short time and to obtain high accurate test results.

In accordance with an aspect of the present invention, there is provided an integrated circuit as defined in claim 1.

A first integrated circuit according to an aspect related to the invention comprises (a) an internal logic circuit, (b) plural input ports for inputting signals to be supplied to the internal logic circuit, (c) plural Schmitt input circuits for outputting signals corresponding to the signals inputted from the plural input ports, respectively, (d) plural output ports outputting signals from the internal logic circuit, and (e) plural switch circuits each connected to the internal logic circuit and to one of the plural Schmitt input circuits and to one of the plural output ports that is selected so as to reduce wiring amount by taking a positional relation between the connected Schmitt input circuit and the plural outputs ports into consideration, and feeding signal from the connected Schmitt circuit to the internal logic circuit or the connected output port.

That is, the first integrated circuit is provided with a switch circuit which can supply the output of the Schmitt input circuit to the output port so as to bypass the internal logic circuit every Schmitt input circuit. The input port to which each switch circuit outputs a signal is determined so as to reduce a wiring amount by taking a positional relation to the corresponding Schmitt input circuit into consideration and so as not to repeat. Thus, each switch in the first integrated circuit is made function, the plural Schmitt input circuits are connected to different output terminal one another.

As the result, in the first integrated circuit, the Schmitt input circuits can be tested without a functional test in parallel, therefore, it takes only a very short time to complete the test of the Schmitt input circuits. Further, during the test, since the internal logic circuit is bypassed, the power current reduces, therefore, the power noise reduces. Thus, it becomes also possible to measure the threshold voltage accurately under no noise influence.

A second integrated circuit according to an aspect related to the invention comprises (a) an internal logic circuit, (b) plural input-output ports for inputting signals to be supplied to the internal logic circuit and for outputting signals from the internal logic circuit, (c) plural Schmitt input circuits outputting signals corresponding to the signals inputted from the plural input-output ports, respectively, (d) plural tristate circuits feeding signals from the internal logic circuit to the plural input-output ports, respectively, (e) a control circuit taking on-off control of the plural tristate circuits, and (f) plural switch circuits each connected to the internal logic circuit and to one of the plural Schmitt input circuits and to one of the plural tristate circuits that is selected so as to reduce wiring amount by taking a positional relation between the connected Schmitt input circuit and the plural tristate circuits into consideration, and feeding signal from the connected Schmitt circuit to the internal logic circuit or the connected tristate circuit.

That is, the second integrated circuit is provided with a switch circuit which can supply the output of the Schmitt input circuit connected with the input-output port to another input-output port so as to bypass the internal logic circuit through the tristate circuit every Schmitt input circuit. The tristate circuit to which each switch circuit outputs a signal is determined so as to reduce a wiring amount by taking a positional relation to the corresponding Schmitt input circuit into consideration and so as not to repeat. Thus, each switch in the second integrated circuit is made function, the plural Schmitt circuits are connected to different input-output terminals one another through the tristate circuits.

Further, the integrated circuit is provided with the control circuit controlling ON and OFF in the tristate circuit. The control circuit controls to make the tristate circuit connected to the same input-output port as a Schmitt input circuit to be tested in an OFF state, and to make the tristate circuit which the output of the Schmitt input circuit is inputted in an ON state. Further, the switch circuit is made function, whereby a half of Schmitt input circuits provided in the integrated circuit can be tested. The remaining Schmitt input circuits can be also tested by changing ON-OFF states in each tristate circuit.

As the result, in the second integrated circuit, the plural input-output ports provided with the Schmitt input circuits can be tested half-and-half, therefore, it takes only a very short time to complete the test of the Schmitt input circuits. Further, during the test, since the internal logic circuit is bypassed, the power current reduces, therefore, the power noise reduces. Thus, it becomes also possible to measure the threshold voltage accurately under no noise influence. Moreover, input-output ports related circuits which are usually arranged to be adjacent in the integrated circuit are merely connected through switch circuits one another, therefore, there is no layout problem such as a wiring area expands.

In fabricating the second integrated circuit, it is desirable that the plural switch circuits and the plural tristate circuits are connected so as to be able to test the plural Schmitt input circuits without changing pairs of input-output ports used for testing the plural Schmitt input circuits. That is, it is desirable that a connection between the respective circuits (selection of circuits to be connected) is performed so as to made a wiring for the test close per two input-output ports.

The second integrated circuit further may comprise (g) an input port for inputting a signal to be supplied to the internal logic circuit, (h) a second Schmitt input circuit outputting a signal corresponding to the signal from the input port, (i) a logic operational circuit inserted between a tristate circuit, which is selected so as to reduce wiring amount from the plural tristate circuit, and corresponding switch circuit, and outputting a logic operational result of signals inputted from the connected switch circuit and a signal input terminal to the connected tristate circuit, and (j) a second switch circuit feeding the signal from the second Schmitt input circuit to the signal input terminal of the logical operational circuit or the internal logic circuit.

That is, when an integrated circuit with an input port used only for the signal input and plural input-output ports is fabricated, it is desirable to add switch circuits and a logic operational circuit (such as an AND circuit and an OR circuit) in order to use an input-output port also as a port which the output signal of the second Schmitt circuit connected to the second Schmitt circuit is outputted.

### BRIEF DESCRIPTION OF THE DRAWINGS

Other objects and advantages of the present invention will become apparent during the following discussion conjunction with the accompanying drawings, in which:
FIG. 1 is a circuit diagram illustrating an outline of an integrated circuit according to the first embodiment of the present invention;
FIG. 2 is a circuit diagram of a switch used in the integrated circuit according to the first embodiment;
FIG. 3 is a view illustrating a correspondence relation between a test signal waveform and an output waveform to explain a characteristic evaluation procedure for a Schmitt inverter in the integrated circuit according to the first embodiment;
FIG. 4 is a view illustrating a correspondence relation between a test signal waveform and an output waveform to explain a characteristic evaluation procedure for a Schmitt inverter in the integrated circuit according to the first embodiment;
FIG. 5 is a circuit diagram illustrating an outline of an integrated circuit according to the second embodiment of the present invention; and,
FIG. 6 is a circuit diagram of a switch used in the integrated circuit of each embodiment.

### DETAILED DESCRIPTION OF THE PREFERRED EMBODIMENTS

Preferred embodiments of the present invention will now be described with reference to the accompanying drawings.

### <First Embodiment>

An integrated circuit in the first embodiment is that circuits for testing Schmitt inverters are added to a micro controller LSI having even-numbered input-output ports connected to Schmitt inverters.

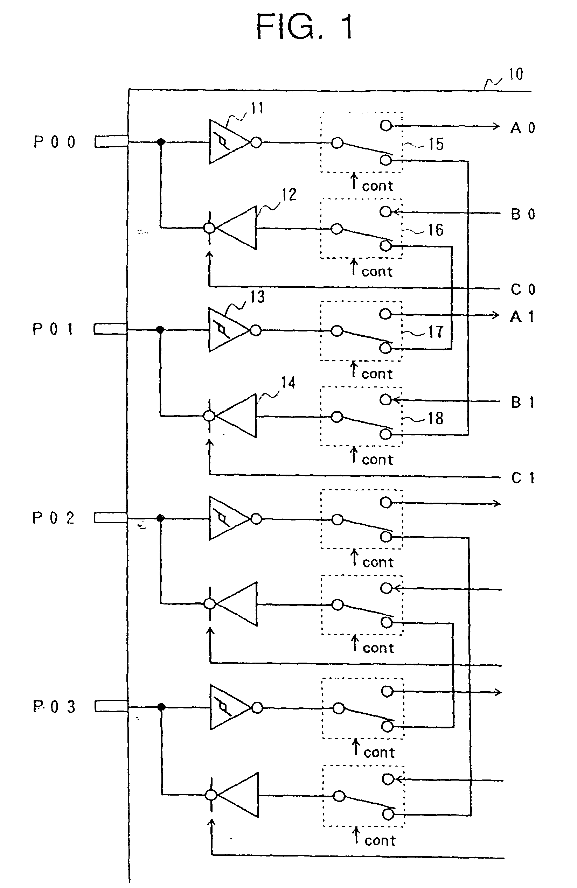

FIG. 1 shows an outline of an integrated circuit according to the first embodiment. As shown in FIG. 1, an input-output port P00 provided in an integrated circuit 10 is connected with an input terminal of a Schmitt inverter 11 and an output terminal of a tristate circuit 12. An input-output port P01 is also connected with a Schmitt inverter 13 and a tristate circuit 14 in the same way.

The output terminals of the Schmitt inverters 11, 13 are respectively connected with common terminals of switches 15, 17. The input terminals of the tristate circuits 12, 14 are respectively connected with common terminals of switches 16, 18. Control signal input terminals of the tristate circuits 12, 14 are respectively connected with nodes C0, C1 of an internal logic circuit (not shown). In usual operation, a control signal for controlling the tristate circuit to become a ON state is inputted to the tristate circuit connected to the input-output port used as an output port. As known, a control (input/output designation) of the tristate circuit like this is programmable in a micro controller LSI. As described later, in this integrated circuit, when each Schmitt inverter is tested, this function is used.

Each switch 15-18 is a circuit having a control signal input terminal, a common terminal, a first terminal and a second terminal, and connects the common terminal to one of the first terminal and the second terminal in accordance with the level of the control signal inputted into the control signal input terminal. The first terminal is connected with the common terminal when no "H" level control signal "cont" is inputted (usual operation). The first terminals of the switches 15-18 are connected with nodes A0, B0, A1, B1 of the internal logic circuit, respectively. The second terminal of the switch 15 (connected to the common terminal when a "H" level control signal cont) is connected with the second terminal of the switch 18, and the second terminal of the switch 17 is connected with the second terminal of the switch 16.

As shown in FIG. 1, the integrated circuit of the first embodiment is structured by arranging these circuits every adjacent two input-output ports.

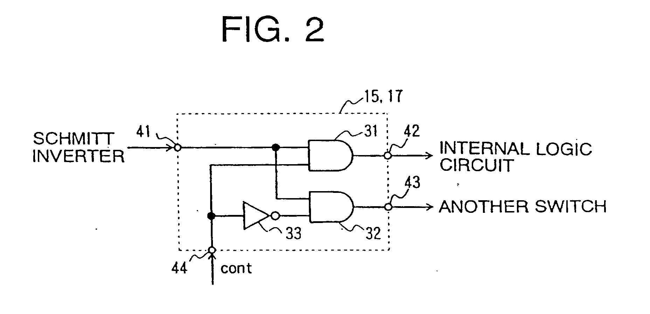

Now, an explanation is given of a structure of a switch used in a post-stage for the Schmitt inverter in the integrated circuit of the first embodiment with reference to FIG. 2. Each of the switches 15, 17, as shown in FIG. 2, is provided with two input AND circuits 31, 32 and an inverter 33. A common terminal 41 connected to the Schmitt inverter is connected with input terminals of the two input AND circuits 31, 32. A control signal input terminal 44 is connected with another input terminal of the two input AND circuits 31, 32. An output terminal of the two input AND circuit 31 is connected to a first terminal 42 connected to the internal logic circuit. Further, a signal from the control signal input terminal 44 is inputted into another input terminal of the two input AND circuit 32 through the inverter 33. The output of the two input AND circuit 32 is supplied to another switch via a second terminal 43.

A switch connected to each tristate circuit is structured similarly, therefore, no explanation thereof is given.

Next, an explanation will be given of the operation in the integrated circuit (test procedure of Schmitt inverter) according to the first embodiment.

When no "H" level control signal "cont" is inputted, in each switch, the common terminal and the first terminal are connected. Thus, in this case, the integrated circuit operates usually without transferring signals between switches.

During the test of the Schmitt inverter, the tristate circuit which is connected with the same input-output port as the Schmitt inverter to be tested is made into a OFF state (inhibit state), and the tristate circuit connected with the other input-output port to be a pair with the one input-output port is made into a ON state.

For example, when the Schmitt inverter connected to the even-numbered input-output port (such as P00, P02) is tested, each tristate circuit connected to the even-numbered input-output port is made in an OFF state, and each tristate circuit connected to the odd-numbered input-output port is made in an active state. Then, the control signal "cont" is supplied to each switch so as to connect the common terminals with the second terminals in all switches.

When each part is controlled to be in this state, the signal from the Schmitt inverter 11 is outputted to the input-output port P01 through the switch 15, the switch 18 and the tristate circuit 14. Similarly, the same level signal as that from the Schmitt inverter connected with another even-numbered input-output port is outputted from the adjacent input-output port to be a pair with that even-numbered input-output port.

Thus, only while a test signal waveform of which the signal level varies step by step is inputted into the even-numbered input-output port, the signal level outputted from the odd-numbered input-output port is measured, whereby it becomes possible to measure a threshold voltage of the Schmitt inverter connected to the even-numbered input-output port.

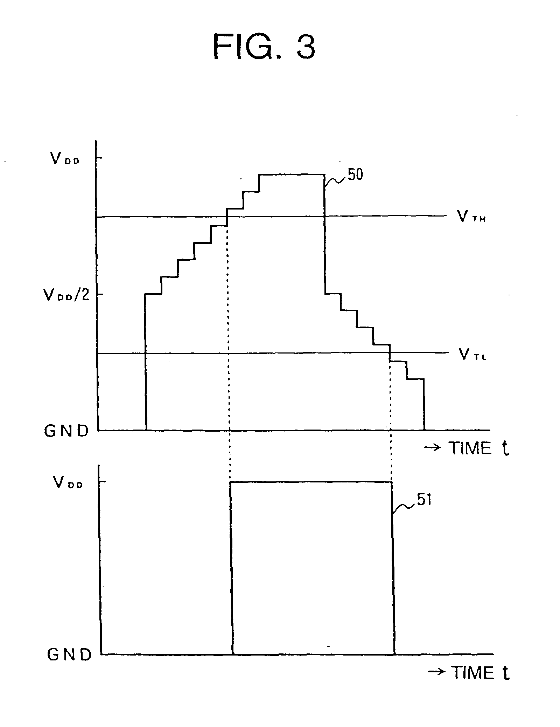

For example, when it is certain that the threshold voltage V_{TH} at the H side of each Schmitt inverter is over the 1/2 V_{DD} and the threshold voltage V_{TL} at the L side is under the 1/2 V_{DD}, a signal outputted from each odd-numbered input-output port, such as a signal which varies with time like the signal waveform 51 is measured individually while a test signal waveform 50 shown in FIG. 3 is supplied to all even-numbered input-output ports, whereby the threshold voltage of each Schmitt inverter can be measured.

That is, first, an input voltage of the GND level is applied to each even-numbered input-output port, and then the input voltage is increased to the 1/2 V_{DD} level. In this while, the "L" level signal is outputted from each odd-numbered input-output port. Thereafter, the signal level outputted from each odd-numbered input-output port is monitored while the input voltage is increased by a predetermined voltage step (such as 0.1V). Then, when there is an input-output port which a signal level is inverted ("H" level signal is outputted), the input voltage at that time is specified. The specified input voltage is set as a threshold V_{TH} at the "H" side of the Schmitt inverter connected to a even-numbered input-output port to be a pair with that input-output port.

Thereafter, when signals from all odd-numbered input-output port reach the "H" level, namely, when all thresholds V_{TH} of Schmitt inverters connected to even-numbered input-output port are measured completely, an input voltage to each even-numbered input-output port is decreased to the 1/2 V_{DD}, and then the signal level from each odd-numbered input-output port of is monitored while the input voltage is decreased by a determined voltage step. Then, when there is an input-output port which a signal level is inverted ("L" level signal is outputted), the input voltage at that time is specified. The specified input voltage is set as a threshold V_{TL} at the "L" side of the Schmitt inverter connected to a even-numbered input-output port to be a pair with that input-output port.

All thresholds V_{TL} of Schmitt inverters connected to even-numbered input-output port are measured completely, and then a state of each tristate circuit is changed in order to test remaining Schmitt inverters. That is, each tristate circuit connected to an odd-numbered input-output port is made in an OFF state, and each tristate circuit connected to an odd-numbered input-output port is made in an active state. Then, a test signal waveform is inputted into each odd-numbered input-output port, and the signal level from each even-numbered input-output port is monitored, whereby threshold voltages V_{TH}, V_{TL} of the Schmitt inverter connected to each odd-numbered input-output port are measured.

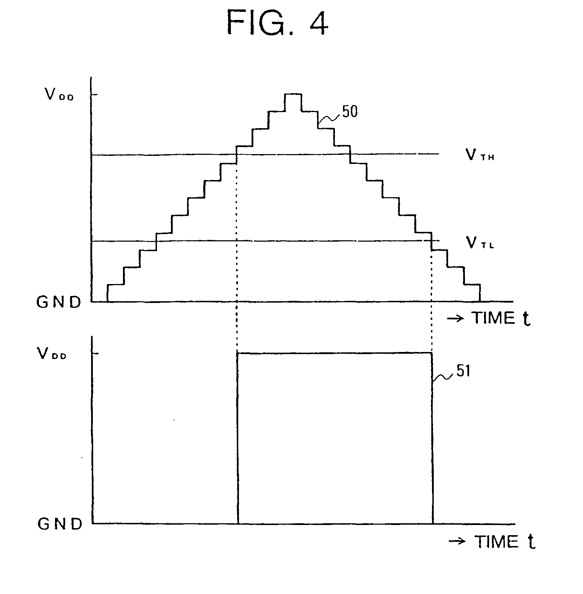

Additionally, a test signal waveform is not limited to that shown in FIG. 3. For example, as shown in FIG. 4, a test signal waveform of which a level varies step by step from the GND level may be used. Further, it is unnecessary to input the same test signal waveform into all input-output ports used as input ports. For example, it is apparent that a test signal waveform to be inputted may be varied according whether a Schmitt inverter to be an object is TTL level Schmitt or CMOS level Schmitt.

As above described, according to the integrated circuit in the first embodiment, plural Schmitt inverters in the integrated circuit can be tested in parallel without a functional test. Thus, it takes only a very short time to complete tests for Schmitt inverters. Further, a Schmitt inverter and a tristate circuit connected to adjacent input-output ports, namely, circuits which are originally arranged close to each other are merely connected by switches, therefore, there is no layout problem such as a wiring ares expands.

Moreover, during the test, the internal logic circuit is completely bypassed, therefore, the power current reduces compared with a case that the threshold is measured by the functional test. Further, power noises reduce, therefore, it becomes possible to measure the threshold voltage under no noise influence accurately.

### <Second Embodiment>

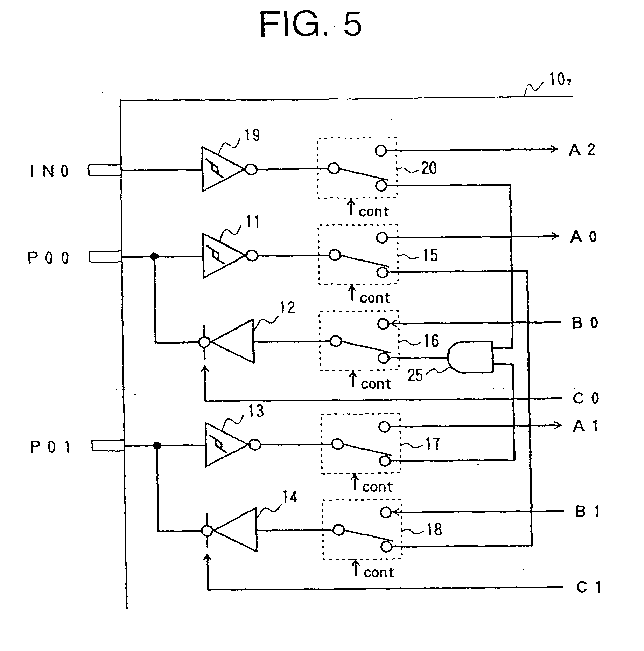

Next, an explanation will be given of a structure of the integrated circuit in the second embodiment with reference to FIG. 5. As shown in FIG. 5, a integrated circuit 10₂ in the second embodiment is provided with an input port IN0 only for input in addition to the input-output ports P01, P02. The input port IN0 is connected with a Schmitt inverter 19, and the output of the Schmitt inverter 19 is inputted into a common terminal of a switch 20. A first terminal of the switch 20 is connected to a node A2 in the internal logic circuit.

The input-output ports P01, P02 are connected to circuits of almost similar structures. In addition, a two input AND circuit 25 is arranged between the second terminal of the switch 16 and the second terminal of the switch 17, and a logical product (operated result of two input AND circuit 25) of a signal from the second terminal of the switch 19 and a signal from the second terminal of the switch 17 is inputted thereto.

In this integrated circuit, each Schmitt inverter is tested in accordance with a procedure mentioned hereinafter.

The Schmitt inverter 11 in no relation to the two input AND circuit 25 is tested in accordance with the same procedure for the integrated circuit in the first embodiment. When Schmitt inverters 13, 19 relative to the two input AND circuit 25 are tested, one input of the two input AND circuit 25 is kept to "H" by supplying a "L" level signal to the input port IN0 and so on. Then, the Schmitt inverter 13 is tested by varying the input voltage to the input-output port P01. Thereafter, the Schmitt inverter 19 is tested by varying the input voltage to the input-output port P00 while a "L" level signal is supplied.

Additionally, when the Schmitt inverters 13, 19 are designed to have the same threshold voltage level, the input voltage at that the signal level from the input-output port P00 is inverted may be set as a threshold voltage of the Schmitt inverters 13, 19 by supplying the same test signal waveform both.

### <Modification>

The integrated circuit explained in the first and second embodiments is provided with Schmitt inverters and inverting tristate circuits, however, the circuit structure explained in each embodiment can be also applied to an integrated circuit with a Schmitt buffer but Schmitt inverters. The circuit structure can be also applied to an integrated circuit with a non-inverting tristate circuit. Incidentally, it is necessary to pay attention to that there is a case in that an output waveform for an input of a test signal waveform varies (logic inverts) in accordance with the application method of the circuit structure explained in each embodiment.

Moreover, in the integrated circuit of the second embodiment, a two input AND circuit is used, however, a two input OR circuit may be also used instead of it. When a two input OR circuit is used, a "H" level signal is inputted into one port, whereby a Schmitt inverter connected to another port is tested. Additionally, when an integrated circuit having odd-numbered input-output ports but an input port is fabricated, a circuit corresponding to a two input AND circuit may be used. That is, in this case, an integrated circuit corresponding to the second embodiment can be fabricated by using one input-output port as an input port.

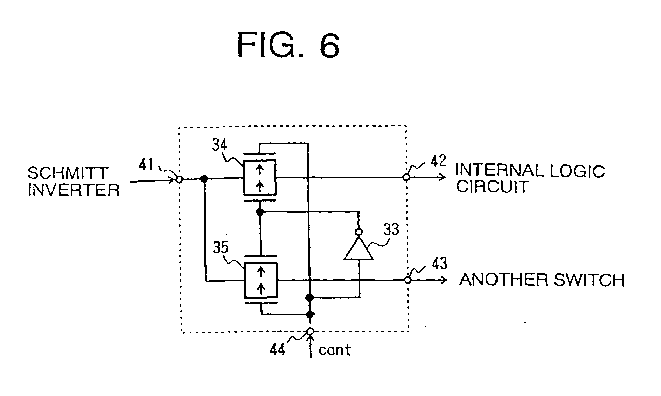

Further, as shown in FIG. 6, a switch including analog switches (transfer gates) 34, 35 and an inverter 33 may be used instead of the switch shown in FIG. 2.

The integrated circuit in each embodiment is the so-called micro controller LSI, however, it is apparent that the present invention may be applied to a general LSI having a Schmitt input circuit.

As explained in detail, the integrated circuit of the present invention is fabricated in a manner that plural Schmitt input circuits can be tested in parallel and in a state that the internal logic circuit is bypassed, therefore, it is possible to evaluate each Schmitt input circuit at a high speed and accurately.

## Claims

1. An integrated circuit comprising:
an internal logic circuit;
a plurality of input ports (P00-P03) inputting input signals to be supplied to the internal logic circuit;
a plurality of input circuits (11, 13) receiving the input signals and outputting signals corresponding to the input signals, respectively; and
a plurality of input ports (P00-P03) outputting output signals from the intemal logic circuit, **characterized in that**
the input circuits are Schmitt circuits (11, 13); and
the integrated circuit further comprises a plurality of switch circuits (15-18) each connected between the internal logic circuit and a corresponding one of the Schmitt circuits (11, 13) and a corresponding one of the output ports (P00-P03) and selectively feeding the input signal from the Schmitt circuits (11, 13) to the internal logic circuit or to the corresponding output ports (P00-P03).

2. An integrated circuit according to claim 1, further comprising a plurality of output circuits (12, 14) connected to the output ports (P00-P03), respectively.

3. An integrated circuit according to claim 2, wherein the output circuits are tristate circuits (12, 14).

4. An integrated circuit according to claim 3, wherein the switch circuits (15-18) and the tristate circuits (12, 14) are connected so as to be able to test the Schmitt circuits (11, 13) without changing pairs of the input ports (P00-P03) and the output ports (P00-P03).

5. An integrated circuit according to claim 1, wherein the input ports and the output ports are commonly provided as input-output ports (P00-P03).

6. An integrated circuit according to claim 1, further comprising:
an individual input port (IN0) for inputting an individual input signal to the internal logic circuit;
an individual Schmitt input circuit (19) receiving the individual input signal and outputting a signal corresponding to the individual input signal;
an individual switch circuit (20) receiving the output signal from the individual Schmitt input circuit (19); and
a logic operational circuit (20) connected to the individual switch circuit (20) and the switch circuits (16, 17), the logic operational circuit (25) outputting a logic operational result signal inputted from the individual switch circuit (20) and one of the switch circuits (17).

7. An integrated circuit according to claim 1, wherein each of the output ports (P00, P01) is connected to a corresponding one of the Schmitt circuits (11, 13) through the switch circuits (15, 17), so as to reduce writing by a positional relationship between the Schmitt circuits (11, 13) and the output ports (P00, P01).

## Patentansprüche

1. Integrierte Schaltung, die umfasst:
eine interne Logikschaltung;
mehrere Eingangsports (P00-P03), die Eingangssignale eingeben, die an die interne Logikschaltung geliefert werden sollen;
mehrere Eingangsschaltungen (11, 13), die die Eingangssignale empfangen und Signale ausgeben, die den jeweiligen Eingangssignalen entsprechen; und
mehrere Eingangsports (P00-P03), die Ausgangssignale von der internen Logikschaltung ausgeben, **dadurch gekennzeichnet, dass**
die Eingangsschaltungen Schmitt-Schaltungen (11, 13) sind; und
die integrierte Schaltung ferner mehrere Schaltschaltungen (15-18) umfassen, wovon jede zwischen die interne Logikschaltung und eine Entsprechende der Schmitt-Schaltungen (11, 13) und einen Entsprechenden der Ausgangsports (P00-P03) geschaltet ist und wahlweise das Eingangssignal von den Schmitt-Schaltungen (11, 13) an die interne Logikschaltung oder an die entsprechenden Ausgangsports (P00-P03) liefert.

2. Integrierte Schaltung nach Anspruch 1, die ferner mehrere Ausgangsschaltungen (12, 14) umfasst, die mit den jeweiligen Ausgangsports (P00-P03) verbunden sind.

3. Integrierte Schaltung nach Anspruch 2, bei der die Ausgangsschaltungen Tristate-Schaltungen (12, 14) sind.

4. Integrierte Schaltung nach Anspruch 3, bei der die Schaltschaltungen (15-18) und die Tristate-Schaltungen (12, 14) so angeschlossen sind, dass sie die Schmitt-Schaltungen (11, 13) testen können, ohne dass Paare der Eingangsports (P00-P03) und der Ausgangsports (P00-P03) geändert werden.

5. Integrierte Schaltung nach Anspruch 1, bei der die Eingangsports und die Ausgangsports gemeinsam als Eingangs/Ausgangs-Ports (P00-P03) vorgesehen sind.

6. Integrierte Schaltung nach Anspruch 1, die ferner umfasst:
einen einzelnen Eingangsport (IN0), um ein einzelnes Eingangssignal in die interne Logikschaltung einzugeben;
eine einzelne Schmitt-Eingangsschaltung (19), die das einzelne Eingangssignal empfängt und ein dem einzelnen Eingangssignal entsprechendes Signal ausgibt;
eine einzelne Schaltschaltung (20), die das Ausgangssignal von der einzelnen Schmitt-Eingangsschaltung (19) empfängt; und
eine Logikoperationsschaltung (20), die mit der einzelnen Schaltschaltung (20) und mit den Schaltschaltungen (16, 17) verbunden ist, wobei die Logikoperationsschaltung (25) ein Logikoperationergebnissignal ausgibt, das von der einzelnen Schaltschaltung (20) und einer der Schaltschaltungen (17) eingegeben wird.

7. Integrierte Schaltung nach Anspruch 1, bei der jeder der Ausgangsports (P00-P01) mit einer Entsprechenden der Schmitt-Schaltungen (11, 13) über die Schaltschaltungen (15, 17) verbunden ist, um das Schreiben durch eine räumliche Beziehung zwischen den Schmitt-Schaltungen (11, 13) und den Ausgangsports (P00-P01) zu verringern.

## Revendications

1. Circuit intégré comportant:
un circuit logique interne,
une pluralité de ports d'entrée (P00 à P03) délivrant en entrée des signaux d'entrée à fournir au circuit logique interne;
une pluralité de circuits d'entrée (11, 13) recevant les signaux d'entrée et délivrant en sortie des signaux correspondant aux signaux d'entrée respectivement; et
une pluralité de ports d'entrée (P00 à P03) délivrant en sortie des signaux de sortie provenant du circuit logique interne, **caractérisé en ce que**
les circuits d'entrée sont des circuits de Schmitt (11, 13); et
le circuit intégré comporte en outre une pluralité de circuits de commutation (15 à 18) connectés chacun entre le circuit logique interne et l'un correspondant des circuits de Schmitt (11, 13) et l'un correspondant des ports de sortie (P00 à P03) et délivrant sélectivement le signal d'entrée provenant des circuits de Schmitt (11, 13) au circuit logique interne ou aux ports de sortie correspondants (P00 à P03).

2. Circuit intégré selon la revendication 1, comportant en outre une pluralité de circuits de sortie (12, 14) connectés aux ports de sortie (P00 à P03) respectivement.

3. Circuit intégré selon la revendication 2, dans lequel les circuits de sortie sont des circuits à trois états (12, 14).

4. Circuit intégré selon la revendication 3, dans lequel les circuits de commutation (15 à 18) et les circuits à trois états (12, 14) sont connectés de manière à être capables de tester les circuits de Schmitt (11, 13) sans changer des paires des ports d'entrée (P00 à P03) et des ports de sortie (P00 à P03).

5. Circuit intégré selon la revendication 1, dans lequel les ports d'entrée et les ports de sortie sont prévus en commun en tant que ports d'entrée-sortie (P00 à P03).

6. Circuit intégré selon la revendication 1, comportant en outre:
un port d'entrée individuel (INO) pour délivrer en entrée un signal d'entrée individuel au circuit logique interne;
un circuit d'entrée de Schmitt individuel (19) recevant le signal d'entrée individuel et délivrant en sortie un signal correspondant au signal d'entrée individuel;
un circuit de commutation individuel (20) recevant le signal de sortie du circuit d'entrée de Schmitt individuel (19); et
un circuit opérationnel logique (20) connecté au circuit de commutation individuel (20) et aux circuits de commutation (16, 17), le circuit opérationnel logique (25) délivrant en sortie un signal de résultat opérationnel logique délivré en entrée par le circuit de commutation individuel (20) et l'un des circuits de commutation (17).

7. Circuit intégré selon la revendication 1, dans lequel chacun des ports de sortie (P00, P01) est connecté à l'un correspondant des circuits de Schmitt (11, 13) via les circuits de commutation (15, 17), de manière à réduire l'écriture par une relation de positionnement entre les circuits de Schmitt (11, 13) et les ports de sortie (P00, P01).
